(19) Europäisches Patentamt
European Patent Office
Office européen des brevets

(11) **EP 1 030 450 B1**

(12) **EUROPEAN PATENT SPECIFICATION**

(45) Date of publication and mention
of the grant of the patent:
**20.10.2004 Bulletin 2004/43**

(51) Int Cl.⁷: **H03K 19/094**, H03K 19/017

(21) Application number: **00102238.3**

(22) Date of filing: **14.02.2000**

(54) **Tristate differential output stage**

Differenzausgangstufe für drei Zustände

Etage de sortie différentiel à trois états

(84) Designated Contracting States:
**AT BE CH CY DE DK ES FI FR GB GR IE IT LI LU MC NL PT SE**

(30) Priority: **18.02.1999 DE 19906860**

(43) Date of publication of application:
**23.08.2000 Bulletin 2000/34**

(73) Proprietor: **TEXAS INSTRUMENTS DEUTSCHLAND GMBH 85356 Freising (DE)**

(72) Inventors:
• **Bareither, Jürgen**
**Richardson Texas 75080 (US)**
• **Seibold, Hermann**
**85410 Haag an d. Amper (DE)**

(74) Representative:
**Degwert, Hartmut, Dipl.-Phys. et al Prinz & Partner GbR, Manzingerweg 7 81241 München (DE)**

(56) References cited:
**EP-A- 0 360 525**      US-A- 4 808 853
**US-A- 5 486 780**      US-A- 5 644 258

**Description**

The invention relates to a tristate differential output stage with two parallel circuit branches, each of which containing two series-connected field effect transistors of different conduction type, which on one side are connected to a supply voltage terminal and on the other to a terminal of a current source whose other terminal is grounded, whereby the gates of the field effect transistors of the one conduction type are connected to each other and where the gates of the two field effect transistors of the other conduction type constitute input terminals, whilst the interconnected drains of the field effect transistors in each one of the circuit branches constitute output terminals.

Tristate differential output stages are put to use in bus interface circuits. These interface circuits serve the purpose of applying the signals generated by a module to a bus, by means of which these can be transferred to another module. The transfer can, in this case, be bidirectional, which means that the signals can also be transferred to a module via the bus and the interface circuit connected to it, whereby they may possibly be further processed. The output stage is here connected to the bus via two output terminals and can assume three states, that is a first state, where the first output terminal receives current and the second output terminal supplies current, a second state where the first output terminal supplies current and the second output terminal receives current, and a third state where both output terminals are in a high-impedance state, that is neither receiving nor supplying current. The last-mentioned state is also known as the Z state. More and more exacting requirements as regards performance are demanded of these tristate differential output stages. In particular, they shall be able to supply a high output current, they shall have a large common-mode voltage range and a low common-mode output current, and their operating speed should be high. When producing such output stages in integrated circuit technology, it is furthermore important that they can be realised with the smallest possible number of components occupying little space on the semiconductor chip.

US-A-5644258 discloses a driver circuit with low idle power consumption which includes a constant current source and a differential MOS transistor pair the drains of each MOS transistor being connected to a series connection of a switch transistor receiving an enable signal and a resistor. The bias current which operates the differential transistor pair is saved during an idle state of the circuit by a de-assertion state of an enable signal.

To achieve the desired high output current from the device when it is realised in the form of an integrated circuit, it is necessary to use field effect transistors of large dimensions, which in turn use up a large amount of space on the semiconductor chip. In order to suppress common-mode noise, the transistors in the individual branches must be switched as simultaneously as possible. Furthermore, the gate capacitance of the transistors must be charged and discharged very rapidly when the output stage switches between its different states, which produces a very high current glitch, particularly during the charging-up process, which may lead to a transient voltage drop of the supply voltage.

This voltage drop, in turn, may affect the circuit at whose output the tristate differential output stage is in operation. Although it would be possible to reduce the current glitch by reducing the switch-over times of the transistors in the circuit branches of the output stage, it would then become very difficult to achieve simultaneous switching of the transistors which, in turn, would lead to a common-mode noise.

The invention rests on the requirement to provide a tristate differential output stage of the type previously described which fulfils the exacting requirements as regards high output current, a large common-mode voltage range at low common-mode output currents, as well as high operating speeds.

According to the invention, these requirements for such an output stage are satisfied by means of a first switch, controlled by a control signal, for the application of a first reference voltage to the interconnected gates of the field effect transistors of the one conduction type, which maintains both these transistors in their off state, a second switch, controllable by the control signal for the application of a second reference voltage to the interconnected gates of the field effect transistors of the one conduction type, which maintains these two transistors in their on state, and a discharge circuit for the generation of a pulse for the discharge of the gate capacitance of the field effect transistors of the one conduction type from the control signal, when this puts the second switch into the on state for the application of the second reference voltage to their gates.

On the basis of the embodiment of the output stage according to the invention, the transistors acting as current sources in the output stage can be switched jointly by means of a switch, whereby this switching action can take place with little voltage swing and no disturbing current glitch is therefore generated. The transistors used as current sources can be realised in relatively small dimensions, so that simultaneous switching becomes possible. The discharge circuit in particular contributes to the rapid discharge of the gate capacitance of the transistors to be switched, thereby resulting in an acceleration of the switching process.

Advantageous further developments of the invention are characterised in the sub-claims.

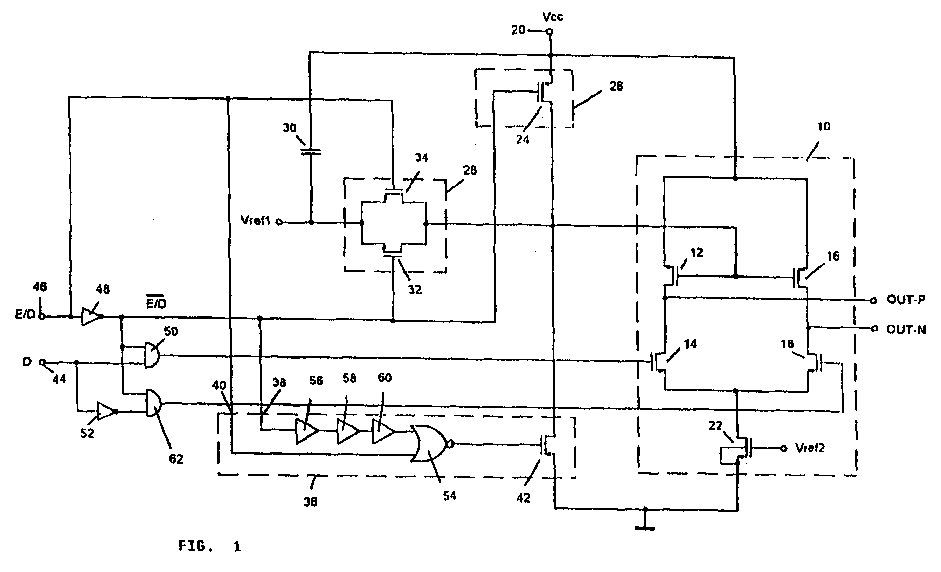

The invention shall now be explained in more detail by way of an exemplified embodiment and by making reference to the drawing, the only figure of which showing a circuit diagram of the tristate differential output stage according to the invention.

The tristate differential output stage represented in the illustration contains a differential circuit block 10 with two parallel circuit branches, each containing two series-connected field effect transistors 12, 14 or 16,18 respectively. The field effect transistors 12 and 16 are p-channel transistors; their gates are connected to each other. The field effect transistors 14 and 18 are n-channel transistors; their gates constitute the signal inputs of the differential circuit block 10. The interconnected drains of transistors 12, 14 and 16, 18, respectively, are the outputs OUT-P and OUT-N. The interconnected sources of the field effect transistors 12 and 16 are connected to a supply terminal 20 which carries the supply voltage Vcc. The interconnected sources of the field effect transistors 14 and 18 are connected to a current source formed by an n-channel field effect transistor 22 whose source is grounded. The gate of this field effect transistor 22 is biased by a reference voltage Vref2 for the adjustment of the current flowing through this field effect transistor.

As can furthermore be appreciated, a first switch 26, formed by a field effect transistor 24 has been provided, by means of which the field effect transistors 12 and 16 can be switched on and off together. By means of a second switch 28, a reference voltage $V_{ref1}$ can be applied to the interconnected gates of the field effect transistors 12 and 16. A capacitor 30, connected between the supply voltage terminal 20 and the circuit point at reference voltage $V_{ref1}$, serves to stabilise the reference voltage $V_{ref1}$ at a constant level. The switch 28 consists of two field effect transistors, connected in parallel, that is an n-channel field effect transistor 32 and a p-channel field effect transistor 34. These two field effect transistors together form a so-called transmission gate, and the are driven, in a manner to be explained further on, so that both are either conducting or cut off.

Furthermore, a discharge circuit 36 is provided which at two inputs 38 and 40 receives the control signals that also control the switch 28. As shall be explained further on, the discharge circuit 36 generates from these two control signals a short discharge pulse, which puts one field effect transistor 42 into the conducting state, thus providing a discharge path for the discharge of the gate capacitance of these transistors between the interconnected gate terminals of transistors 12 and 16 and ground, for the duration of this short discharge pulse.

The signals for the control of the output stage 10 are applied to a data input 44 via an enable/disable input 46. The signal applied to the data input 44 is normally designated as D, whilst the enable/disable signal is designated E/D. As can be appreciated, the output stage also generates the inverted signal $\overline{E/D}$ from the enable/disable signal E/D by inversion in a negator 48. By combining in an AND circuit 50 and by inversion in a negator 52, the negated enable/disable signal $\overline{E/D}$ and the data signal D are used to generate the signals IN-P and IN-N required for the control of the differential circuit block 10.

The mode of operation of the output stage, so far described from the point of view of arrangement, shall now be explained in more detail.

For the following description of the mode of operation it is assumed that the tristate differential output stage is in its Z state, that is in the state where both the outputs OUT-P and OUT-N are in their high impedance condition. This Z state prevails when the enable/disable signal E/D at input 46 has the high signal value H, i.e. has a voltage value in the region of the supply voltage Vcc. The inverted signal $\overline{E/D}$ then has the low signal value L, i.e. has a value in the region of ground voltage, which has as a consequence that the transistor 24 in switch 26 is in its conducting state, so that a high voltage is applied to the gates of the field effect transistors 12 and 16, which in the present example would be around 3.6 V, once the voltage drop at the field effect transistor 24 has been taken into account. This voltage puts the field effect transistors 12 and 16 into the off state.

As a result of the high value H of the enable/disable signal E/D and the corresponding low signal value L of the inverted enable/disable signal $\overline{E/D}$, the transistors 34 and 32, respectively, in switch 28 are in their off state, so that the reference voltage $V_{ref1}$ cannot reach the gates of the field effect transistors 12 and 16.

It shall now be assumed that the output stage is put into the active state in which, depending on the signal D at the input 44, the output current of the differential circuit section 12 can flow from the output OUT-P to the output OUT-N or, alternatively, from the output OUT-N to the output OUT-P. The switch-over of the enable/disable signal E/D from its high value H to its low value L, and the corresponding switch-over of the inverted enable/disable signal $\overline{E/D}$ from its low value L to its high value H, the following effects take place at the same time:

a) The field effect transistor 24 in switch 26 goes into its off state, so that the previously-mentioned high voltage of 3.6 V is no longer applied to the gates of the field effect transistors 12 and 16.

b) The field effect transistors 32 and 34 in switch 28 are put into their on state, so that the reference voltage $V_{ref1}$, stabilised by the capacitor 30, is applied to the gates of the field effect transistors 12 and 16. In the example described, this voltage $V_{ref1}$ has the value 2.9 V. The consequence of this is that the field effect transistors 12 and 16 pass into the on state, to be able to assume their function as current sources.

c) The enable/disable signal E/D reaches a NOR circuit 54 within the discharge circuit 36, and the inverted enable/disable signal $\overline{E/D}$ reaches the other input of the NOR circuit 48, delayed by three buffer circuits 56, 58 and 60. Because of the delayed arrival of the signals at the NOR circuit 54, the signals present at their inputs will briefly have the same signal value, that is the low value L, which leads to the presence of a signal with the high value H at its output. This high signal value H, present only for a short duration, has as a consequence that the field effect transistor 42 goes into the on state for the duration of this short time span, so that a discharge path is produced for the interconnected gates of field effect transistors 12 and 16 to ground. This discharge path allows the rapid discharge of the gate capacitance of field effect transistors 12 and 16, so that the transition of these field effect transistors into the on state can be correspondingly fast. Without this discharge path, the gate capacitance would have to be discharged via the source supplying the reference voltage $V_{ref1}$ but this discharge process could not take place at the same high speed.

It should be noted chat for the transition of the field effect transistors 12 and 16 from their off state into their on state only a gate voltage change from 3.6 V to 2.9 V has to take place, meaning that only a small voltage swing occurs. The same applies when the conditions are reversed, that is when the field effect transistors 12 and 16 have to be switched from the on state into the off state, where their gate voltage only has to be increased by 0.7 V from 2.9 V to 3.6 V. In both cases, this small voltage swing is very quickly accomplished and does not even cause a large disturbing pulse in the supply current. Common mode noise is hereby effectively suppressed.

When the tristate differential output stage is in its active state, the application of the corresponding data signal D to the input 44 can cause either the field effect transistor 14 or the field effect transistor 18 to be put into the on state. By integrating the inverted enable/disable signal $\overline{E/D}$ into the AND circuits 50 and 62 a condition is obtained where only in the enabled or active state of the output stage the data signal D, depending on its value (H or L), can put one of the two field effect transistors 14 or 18 into its on state. If, for example, the data signal D has the high signal value H, a signal of the high value H will also be present at the output of the AND circuit 50, which will put the field effect transistor 14 into its on state. At the same time, by inversion in the negator 52, a signal with the low value L is applied to the AND circuit 62, so that its output signal also assumes the low value L, thereby cutting the field effect transistor 18 off. In this condition, a current path is established in the differential circuit section 10 of the output from the supply voltage terminal 20 via the field effect transistor 16, the output terminal OUT-N and from there to the connected circuit and from there via the output terminal OUT-P and the field effect transistor 14, as well as via the field effect transistor 22, leading finally to ground. The field effect transistor 22, which acts as a current source, is biased by the reference voltage $V_{ref2}$ so that the total desired current can flow through it.

When, however, the data signal D at input 44 has the low value L, the AND circuit 50 also outputs a signal with the low value L, so that the field effect transistor 14 is cut off. However, a signal with the high value H is applied to the gate of field effect transistor 18 via negator 52 and AND circuit 62, which puts this field effect transistor into the on state. The current path in the differential circuit section 10 now runs from the supply current terminal 20, via field effect transistor 12, the output terminal OUT-P, the circuit connected to it, the output terminal OUT-N, the field effect transistor 18 and the field effect transistor 22 to ground.

Therefore, by means of the data signal D, the output stage can be put into the two desired operating conditions. As has been mentioned, the output stage can be de-activated or activated by means of the enable/ disable signal E/D.

It has been shown that the tristate differential output stage described fulfils the corresponding requirements as regards the rapidity of the switch-over between the different operating states, whilst reducing common mode disturbances at the same time. Furthermore, no large current sources with correspondingly large transistors are required, with the result that, when produced as an integrated circuit on a semiconductor chip, very little space is required.

**Claims**

1. Tristate differential output stage with two parallel circuit branches, each of which containing series-connected field effect transistors of different conduction type, and which on one side are connected to a supply voltage terminal and on the other to a terminal of a current source whose other terminal is grounded, whereby the gates of the field effect transistors of the one conduction type are connected to each other and where the gates of the two field effect transistors of the other conduction type constitute input terminals, whilst the interconnected drains of the field effect transistors in each one of the circuit branches constitute output terminals, where a first switch (26), controllable by means of a control signal ($\overline{E/D}$), for the application of a first reference voltage to the interconnected gates of the field effect transistors (12,16) of the one conduction type, which maintains these two transistors in their off state, a second switch (28), controllable by the control signal (E/D, $\overline{E/D}$) for the application of a second reference voltage to the interconnected gates of the field effect transistors (12, 16) of the one conduction type, which maintains these two transistors in their on state, and a discharge circuit (36) for the generation of a pulse for the discharge of the gate capacitance of both field effect transistors (12, 16) of the one conduction type by virtue of the control signal (E/D, $\overline{E/D}$), when this puts the second switch (28) into the on state for the application of the second reference voltage to their gates.

2. Tristate differential output stage according to claim 1, where the two switches (26, 28) are made up of the field effect transistors (24; 32, 34), whereby the second switch (28) consists of two field effect transistors (32, 34) of opposite conduction type, connected in parallel, to whose gates is applied the control signal in either direct (E/D) or alternatively inverted ($\overline{E/D}$) form, so that the two field effect transistors (32, 34) together will always be either on or off at the same time, depending on the control signal.

3. Tristate differential output stage according to claims 1 or 2, where the discharge circuit (36) contains a NOR circuit (54), which at one input receives the control signal without delay in its direct form (E/D), and at the other receives the control signal in its inverted form ($\overline{E/D}$) and delayed by at least one delay element (50, 52, 54), that the delay time of the delay element is set so that the signals at both inputs of the NOR circuit (54) have the same signal value only for the desired duration of the discharge pulse which at the output of the NOR circuit (54) causes the generation of the discharge pulse, and that a further switch (42) is connected to the output of the NOR circuit (54), which under the control of the discharge pulse, and for its duration, provides a discharge path for the gate capacitance of both the field effect transistors (12, 16) of the same conduction type in the parallel circuit branches.

**Patentansprüche**

1. Tristate-Differenz-Ausgangsstufe mit zwei parallelen Schaltungszweigen, die jeweils in Serie geschaltete Feldeffekttransistoren unterschiedlichen Leitungstyps enthalten, und die einerseits mit einer Versorgungsspannungsklemme und andererseits mit einem Anschluß einer Stromquelle verbunden sind, deren anderer Anschluß an Masse liegt, wobei die Gate-Anschlüsse der Feldeffekttransistoren des einen Leitungstyps miteinander verbunden sind und die Gate-Anschlüsse der beiden Feldeffekttransistoren des anderen Leitungstyps Eingangsanschlüsse bilden, während die verbundenen Drain-Anschlüsse der Feldeffekttransistoren in jeweils einem Schaltungszweig Ausgangsanschlüsse bilden, **gekennzeichnet durch** einen mittels eines Steuersignals ($\overline{E/D}$) steuerbaren ersten Schalter (26) zum Anlegen einer ersten Referenzspannung an die verbundenen Gate-Anschlüsse der Feldeffekttransistoren (12, 16) des einen Leitungstyps, die diese beiden Transistoren im gesperrten Zustand hält, einen mittels des Steuersignals (E/D, $\overline{E/D}$) steuerbaren zweiten Schalter (28) zum Anlegen einer zweiten Referenzspannung an die verbundenen Gate-Anschlüsse der Feldeffekttransistoren (12, 16) des einen Leitungstyps, die diese beiden Transistoren im leitenden Zustand hält, und eine Entladeschaltung (36) zur Erzeugung eines Impulses zum Entladen der Gate-Kapazitäten der Feldeffekttransistoren (12, 16) des einen Leitungstyps aus dem Steuersignal (E/D, $\overline{E/D}$), wenn dieses den zweiten Schalter (28) in den leitenden Zustand zum Anlegen der zweiten Referenzspannung an deren Gate-Anschlüsse versetzt.

2. Tristate-Differenz-Ausgangsstufe nach Anspruch 1, **dadurch gekennzeichnet, daß** die beiden Schalter (26, 28) von den Feldeffekttransistoren (24; 32, 34) gebildet sind, wobei der zweite Schalter (28) aus zwei parallel geschalteten Feldeffekttransistoren (32, 34) entgegengesetzten Leitungstyps besteht, an deren Gate-Anschlüsse das Steuersignal in direkter (E/D) bzw. invertierter ($\overline{E/D}$) Form angelegt wird, so daß die beiden Feldeffekttransistoren (32, 34) abhängig vom Steuersignal immer gleichzeitig leitend oder gleichzeitig gesperrt sind.

3. Tristate-Differenz-Ausgangsstufe nach Anspruch 1 oder 2, **dadurch gekennzeichnet, daß** die Entladeschaltung (36) eine NOR-Schaltung (54) enthält, die an einem Eingang das Steuersignal in direkter Form (E/D) unverzögert und am anderen Eingang das Steuersignal in invertierter Form ($\overline{E/D}$) über wenigstens ein Verzögerungsglied (50, 52, 54) empfängt, daß die Verzögerungszeit des Verzögerungsglieds so eingestellt ist, daß die Signale an den beiden Eingängen der NOR-Schaltung (54) nur für die gewünschte Dauer des Entladeimpulses den gleichen Signalwert haben, der am Ausgang der NOR-Schaltung (54) zur Abgabe des Entladeimpulses führt, und daß mit dem Ausgang der NOR-Schaltung (54) ein weiterer Schalter (42) verbunden ist, der unter der Steuerung durch den Entladeimpuls für dessen Dauer einen Entladeweg für die Gate-Kapazitäten der beiden Feldeffekttransistoren (12, 16) des gleichen Leitungstyps in den parallelen Schaltungszweigen herstellt.

**Revendications**

1. Étage de sortie différentielle à trois états avec deux branches de circuits parallèles, chacune desquels contenant des transistors à effet de champ connectés en série à différent type de conduction, et qui sur un côté sont connectés à une borne de tension d'alimentation et sur l'autre à une borne d'une source de courant dont l'autre borne est mise à la masse, moyennant quoi les grilles des transistors à effet de champ du premier type de conduction sont connectées entre elles et où les grilles des deux bornes à effet de champ de l'autre type de conduction constituent des bornes d'entrée, tandis que les drains interconnectés des transistors à effet de champ dans chacune des branches du circuit constituent des bornes de sortie, où un premier commutateur (26), pouvant être commandé au moyen d'un signal de commande ($\overline{E/D}$), pour l'application d'une première tension de référence aux grilles interconnectées des transistors à effet de champ (12, 16) du premier type de conduction, qui maintient ces deux transistors dans leur état bloqué, un second commutateur (28), pouvant être commandé par le signal de commande (E/D, $\overline{E/D}$) pour l'application d'une seconde tension de référence aux grilles interconnectées des transistors à effet de champ (12, 16) du premier type de conduction, qui maintient ces deux transistors dans leur état passant, et un circuit de décharge (36) pour la génération d'une impulsion pour la décharge de la capacité de grille des deux transistors à effet de champ (12, 16) du premier type de conduction en raison du signal de commande (E/D, $\overline{E/D}$ ), lorsque celui-ci met le second commutateur (28) à l'état passant pour l'application de la seconde tension de référence à leurs grilles.

2. Étage de sortie différentielle à trois états selon la revendication 1, où les deux commutateurs (26, 28) sont faits des transistors à effet de champ (24 ; 32, 34), moyennant quoi le second commutateur (28) comprend deux transistors à effet de champ (32, 34) de type de conduction opposé, connectés en parallèle, aux grilles desquels est appliqué le signal de commande soit sous forme directe (E/D) soit sous forme alternativement inversée ($\overline{E/D}$), de sorte que les deux transistors à effet de champ (32, 34) ensemble soient toujours soit passants, soit bloqués en même temps, en fonction du signal de commande.

3. Étage de sortie différentielle à trois états selon la revendication 1 ou 2, où le circuit de décharge (36) contient un circuit NON-OU (54), qui à une entrée reçoit le signal de commande sans retard sous sa forme directe (E/D), et à l'autre reçoit le signal de commande sous sa forme inversée ($\overline{E/D}$) et retardé par au moins un élément de retard (50, 52, 54), que le temps de retard de l'élément de retard est défini de sorte que les signaux aux deux entrées du circuit NON-OU (54) aient la même valeur de signal uniquement pendant la durée souhaitée de l'impulsion de décharge qui, à la sortie du circuit NON-OU (54), entraîne la génération de l'impulsion de décharge, et qu'un commutateur supplémentaire (42) est connecté à la sortie du circuit NON-OU (54), qui, sous la commande de l'impulsion de décharge, et pendant sa durée, fournit un chemin de décharge pour la capacité de grille des deux transistors à effet de champ (12, 16) du même type de conduction dans les branches de circuit parallèles.

FIG. 1

EP 1 030 450 B1